# FASCICULE DE BREVET EUROPEEN

(11) **EP 0 387 143 B1**
(45) Date de publication et mention de la délivrance du brevet: **29.06.1994**
(21) Numéro de dépôt: 90400609.5
(22) Date de dépôt: 06.03.1990
(51) Int. Cl.: H01F 41/26, G11B 5/31

(54) **Procédé de dépôt électrolytique sur un substrat semiconducteur**
Elektrolytisches Niederschlagsverfahren auf ein Halbeitersubstrat
Method of electrolytic deposition on a semiconductor substrate

(30) Priorité: 08.03.1989 FR 8903027
(43) Date de publication de la demande: 12.09.1990
(73) Titulaire: COMMISSARIAT A L'ENERGIE ATOMIQUE, 75015 Paris Cédex 15 (FR)
(72) Inventeur: Braisaz, Thierry, F-38120 Saint Egreve (FR); Deroux-Dauphin, Patrice, F-38120 Saint Egreve (FR); Poupon, Gilles, F-38170 Seyssinet Pariset (FR)
(74) Mandataire: Signore, Robert

(56) Documents cités:
- US-A- 3 492 546
- US-A- 3 553 533
- US-A- 4 321 283
- JOURNAL OF APPLIED PHYSICS vol. 46, no. 1, janvier 1975, NEW YORK, USA pages 452 - 453; L.M. SCHIAVONE et al.: "Ohmic contacts for moderately resistive p-type InP"

## Description

La présente invention a pour objet un procédé de dépôt électrolytique sur un substrat semi-conducteur. Elle trouve une application notamment dans la réalisation de têtes magnétiques d'écriture et/ou de lecture, intégrées sur un substrat semi-conducteur.

La technique du dépôt électrolytique peut être utilisée dans la réalisation de têtes magnétiques. C'est ce qui est décrit notamment dans le document de brevet US-A-4,402,801 délivré le 6 Septembre 1983. La figure 1 annexée illustre schématiquement cette technique. Si le substrat est conducteur (par exemple en Al₂O₃-TiC), l'électrolyse s'effectue en prenant le substrat 11 comme électrode (partie a). Une couche isolante 12 convenablement gravée permet de définir des zones de croissance électrolytique 17. Si le substrat 11 est isolant, une couche conductrice 16 (par exemple en Ni-Fe) est préalablement déposée pour constituer l'électrode sur laquelle on vient faire croître le dépôt électrolytique 17 (partie b de la figure).

Lorsque le substrat n'est ni isolant ni conducteur mais semi-conducteur, par exemple en silicium, la première variante n'est plus possible. En effet, il n'y aurait pas d'adhérence du dépôt électrolytique sur le semi-conducteur. Seul le recours à une couche conductrice auxiliaire permet le dépôt électrolytique. C'est ce qui est décrit dans le document de brevet européen EP-A-0 262 028.

Or, cette technique présente des inconvénients. La couche conductrice servant d'électrode doit être gravée avant que ne s'effectue le dépôt électrolytique et cette gravure laisse subsister immanquablement des particules métalliques sur la plaquette semi-conductrice. Sur ces particules, on observera des croissances électrolytiques intempestives.

On pourrait laisser intégralement la couche conductrice servant d'électrode, mais il faudrait alors déposer sur celle-ci une couche isolante qu'il conviendrait de graver pour délimiter les seules zones où le dépôt doit avoir lieu, ce qui est complexe.

Enfin, la couche conductrice servant d'électrode augmente l'épaisseur de la structure.

La présente invention a justement pour objet un procédé qui évite ces inconvénients. A cette fin, elle préconise de réaliser, sur la face du semi-conducteur où doit s'effectuer le dépôt électrolytique, des zones de croissance obtenues en faisant diffuser un métal ou un composé métallique en recuisant cette face. Le dépôt électrolytique va alors croître uniquement sur ces zones, par amenée de courant à travers le substrat semi-conducteur, lequel aura été revêtu de manière avantageuse, sur sa face arrière, d'une couche conductrice.

Les inconvénients liés à la couche métallique servant d'électrode sont donc supprimés puisque toute couche métallique en face avant est éliminée avant la réalisation du dépôt électrolytique.

La technique de l'invention se prête bien, par ailleurs, à un dépôt au fond de caissons très étroits ou sur des surfaces de très faibles dimensions, situations que l'on rencontre fréquemment dans le cas des têtes magnétiques intégrées.

Enfin, il n'y a plus lieu, comme dans l'art antérieur (cf EP-A-0 262 028), de redéposer des couches conductrices pour constituer de nouvelles électrodes destinées à de nouveaux dépôts électrolytiques venant se superposer à des dépôts antérieurs.

Il faut observer qu'on connaît également un autre procédé de dépôt électrolytique par le document US-A-3 492 546. Selon cet autre procédé, pour former de bons contacts ohmiques, on dépose une couche d'aluminium sur un substrat semi-conducteur aux endroits appropriés, et on élève la température de l'ensemble pour former un alliage entre l'aluminium et le semi-conducteur. Il subsiste alors une couche d'aluminium qui sert d'électrode pour une opération de croissance électrolytique d'aluminium.

Cette technique résoud les problèmes liés à l'obtention de bons contacts ohmiques. Mais l'obtention d'une couche magnétique, solidement accrochée et de forme complexe, en pose de tout autres. Selon l'invention, après diffusion du métal dans le semi-conducteur, une gravure métallique permet de supprimer toutes particules métalliques, aussi bien sur la couche barrière que sur les zones diffusées. Aussi, le dépôt électrolytique se faisant uniquement sur les zones diffusées, ce dépôt est-il réalisé sans interface avec le substrat, ce qui permet d'éviter des pertes ohmiques, tout risque de décollement et tout dépôt parasite (en particulier il n'est pas nécessaire d'isoler les zones où la croissance électrolytique ne doit pas se produire).

Par ailleurs, l'invention met l'accent sur le rôle privilégié joué par le nickel, car ce métal permet, d'une part, de former des zones diffusées en siliciure de nickel (lorsque le substrat est en silicium) et, d'autre part, de former des couches magnétiques par exemple en fer-nickel. Il y a alors adaptation physico-chimique entre les zones diffusées et le dépôt électrolytique.

De façon plus précise, la présente invention a pour objet un procédé de dépôt électrolytique d'un matériau magnétique sur un substrat semi-conducteur, qui comprend les opérations suivantes :
- on utilise un substrat semi-conducteur faiblement résistif,
- on dépose sur une face avant du substrat un métal ou un composé métallique aux endroits où doit être réalisé le dépôt électrolytique,
- on recuit l'ensemble pour faire diffuser une partie du métal ou du composé métallique dans le substrat,
- on enlève le métal ou le composé métallique restant sur le substrat,
- on met la face avant en contact avec une solution électrolytique correspondant au matériau à déposer,
- on porte le substrat à un potentiel approprié pour provoquer un dépôt électrolytique dudit matériau sur les endroits diffusés.

De toute façon, les caractéristiques et avantages de l'invention apparaîtront mieux après la description qui suit, d'exemples de réalisation donnés à titre explicatif et nullement limitatif. Cette description se réfère à des dessins annexés sur lesquels :

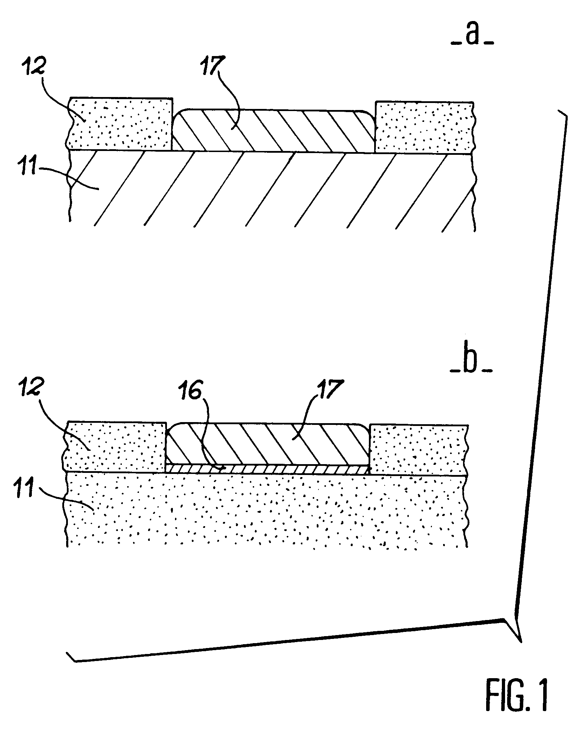

- la figure 1, déjà décrite, rappelle l'art antérieur,
- la figure 2 montre trois étapes principales du procédé de l'invention,
- la figure 3 montre un mode de réalisation avec caisson rectangulaire,
- la figure 4 montre un mode de réalisation avec caisson enterré,
- la figure 5 illustre la réalisation d'un circuit magnétique à plusieurs étages,
- la figure 6 montre en perspective (a) et en coupe (b) une plaquette de silicium ouvragée selon le procédé de l'invention.

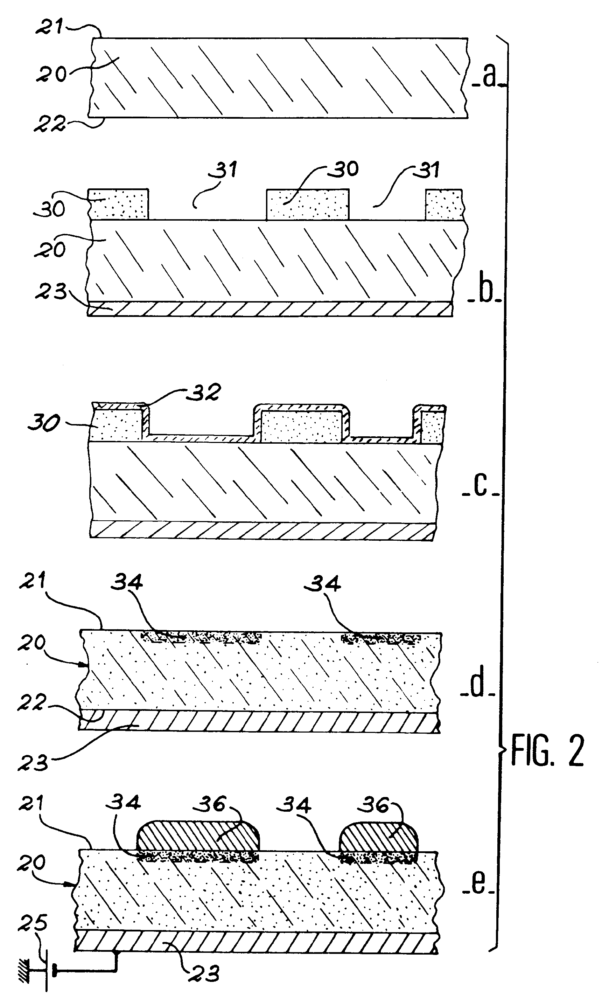

On voit, sur la figure 2 (partie a), un substrat semi-conducteur 20, par exemple en silicium de faible résistivité (10⁻² Ω cm ou moins), poli sur ses deux faces, l'une à l'avant, référencée 21, l'autre à l'arrière référencée 22.

On dépose, (partie b) sur la face arrière 22, une couche métallique 23, par exemple par pulvérisation cathodique, d'épaisseur environ 200 nm. Le conducteur peut être du chrome. Il se forme ainsi un contact ohmique entre le conducteur 23 et le semi-conducteur 20.

Sur la face avant 21, on forme une couche barrière 30 (c'est-à-dire ne permettant pas la diffusion du métal ou du composé métallique dans cette couche) telle que du SiO₂. Cette couche 30 est formée par oxydation thermique ou par dépôt PECVD d'une épaisseur d'environ 1000 nm. Par gravure partielle, on délimite des zones 31 où l'on veut effectuer une diffusion de métal ou de composé métallique.

On dépose ensuite, par exemple par pulvérisation cathodique, une couche d'environ 200 nm de métal ou de composé métallique 32 (partie c). On effectue alors un recuit de l'ensemble (ou au moins de la face avant) pour faire diffuser le métal ou le composé métallique dans les zones délimitées du substrat. On obtient ainsi des zones diffusées 34.

La couche métallique 32 restant sur la couche barrière 30, et le cas échéant, sur les zones 34, est alors gravée chimiquement (partie d). La couche 30 est à son tour éliminée.

Pour une couche 32 en nickel, le recuit peut s'opérer entre 250 et 350°C lorsque le siliciure désiré est Ni₂Si ou entre 350 et 750°C lorsque le siliciure est NiSi. Un recuit à 500°C pendant deux heures permet d'obtenir une couche de siliciure de 50 à 200 nm. Mais on peut également effectuer un recuit très bref ("flash") par exemple à 600°C pendant 30 secondes pour obtenir du Ni₂Sᵢ.

Le matériau diffusé n'est pas limité au nickel. Il peut s'agir aussi de chrome, de titane ou de tungstène.

Ce recuit peut être obtenu sous vide. Dans le cas d'un recuit lent, il peut s'agir d'un vide secondaire ; pour un recuit "flash", un vide de 10⁻³ mb est approprié.

On peut opérer également sous gaz neutre, sous argon par exemple.

La partie (e) de la figure 2 montre l'étape de croissance électrolytique. La couche conductrice arrière 23 est reliée à la borne négative d'une source de tension 25 délivrant une tension et un courant appropriés et l'on met la face avant 21 en contact avec une solution électrolytique correspondant au matériau à déposer (en pratique les cations de cette solution correspondront au métal à déposer).

Dans cette étape, la plaquette de silicium constitue un support très homogène en courant et forme une masse équipotentielle.

Les zones diffusées 34 forment des zones d'accrochage du dépôt électrolytique, alors qu'en dehors de ces zones l'adhérence est insuffisante pour qu'un tel dépôt se forme. Les dépôts 36 vont donc se former seulement en regard des zones 34.

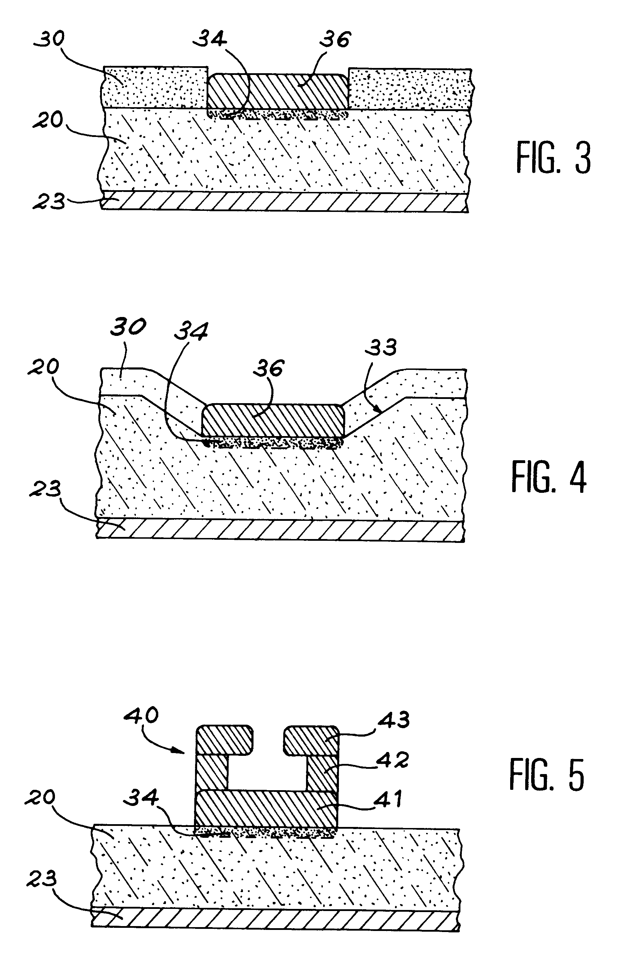

Les figures 3 et 4 illustrent la mise en oeuvre du procédé de l'invention au fond de caissons étroits.

Sur la figure 3, on voit la couche barrière 30 qui est maintenue après gravure de la couche de métal restante, contrairement au cas de la figure 2. Cette couche 30 délimite des caissons au fond desquels, comme précédemment se trouvent les zones diffusées 34. La couche 36 est ensuite déposée électrolytiquement. Dans ce cas, la couche 30 doit être isolante. Il est plus avantageux d'effectuer l'électrolyse comme dans le cas de la figure 3, c'est-à-dire avec une couche isolante 30. En effet, cette dernière permet d'éviter d'éventuels dépôts métalliques parasites sur le substrat au cours de l'électrolyse. Cette couche est ensuite conservée ou éliminée par gravure suivant l'application.

Sur la figure 4, le substrat 20 est préalablement gravé sous forme d'une tranchée 33. La zone 34 est diffusée au fond de cette tranchée, le dépôt électrolytique 36 n'affecte que la tranchée. Il est réalisé de manière avantageuse en présence de la couche isolante 30.

Ces différents caissons peuvent avoir une dizaine de microns de profondeur et plusieurs milliers ou centaines de milliers de microns carrés.

La figure 5 montre un circuit magnétique 40 formé de trois étages 41, 42, 43 obtenus à l'aide d'une seule zone d'accrochage 34.

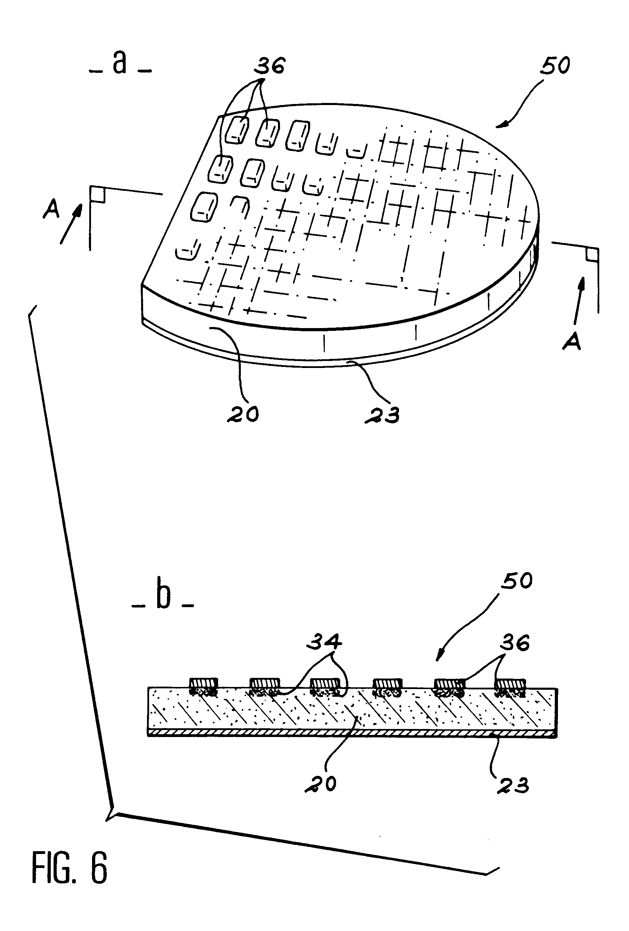

Enfin, la figure 6 montre une plaquette de semi-conducteur 50, par exemple du silicium, (en perspective sur la partie (a) et en coupe selon A sur la partie (b)). La face arrière de la plaquette est revêtue d'une couche conductrice 23. Par le dépôt d'une couche barrière isolante et par gravure partielle de celle-ci, on définit des caissons de 1000 à 100000 microns carrés au fond desquels on réalise la diffusion d'une couche métallique par dépôt et recuit de cette couche afin de former des zones 34 de siliciure. Une gravure de la couche métallique restante permet de débarrasser la plaquette de toute couche métallique en face avant. Il ne reste alors qu'une pluralité de zones 34 de siliciure. Par électrolyse, on forme ensuite sur l'ensemble une pluralité de plots 36. Le reste de la couche barrière peut être alors éliminé.

La suite des opérations conduisant à une tête d'écriture-lecture peut être conforme à l'art antérieur et notamment au procédé décrit dans EP-A-0 262 028.

## Revendications

1. Procédé de dépôt électrolytique d'un matériau magnétique sur un substrat semi-conducteur, qui comprend les opérations suivantes :
- on utilise un substrat semi-conducteur (20) faiblement résistif,
- on dépose sur une face avant (21) du substrat un métal ou un composé métallique aux endroits (31) où doit être réalisé le dépôt électrolytique,
- on recuit l'ensemble pour faire diffuser une partie du métal ou du composé métallique dans le substrat,
- on enlève le métal ou le composé métallique restant sur le substrat,
- on met la face avant (21) en contact avec une solution électrolytique correspondant au matériau à déposer,
- on porte le substrat à un potentiel approprié pour provoquer un dépôt électrolytique (36) dudit matériau sur les endroits diffusés (34).

2. Procédé selon la revendication 1, caractérisé par le fait que l'on dépose sur la face avant du substrat une couche isolante (30), on grave cette couche isolante pour former des caissons (31), on dépose sur la couche isolante gravée et au fond des caissons, une couche de métal ou de composé métallique (32), on recuit l'ensemble pour faire diffuser le métal ou le composé métallique dans le substrat au fond des caissons, on enlève la couche métallique restante sur la couche isolante et au fond des caissons et on forme le dépôt électrolytique (36) dans les caissons sur les endroits diffusés (34).

3. Procédé selon la revendication 2, caractérisé par le fait que l'on grave préalablement le substrat selon des tranchées (33) et on forme les caissons au fond de ces tranchées.

4. Procédé selon l'une quelconque des revendications 1 à 3, caractérisé par le fait que le matériau magnétique (26) est à base de nickel.

5. Procédé selon l'une quelconque des revendications 1 à 4, caractérisé par le fait que le métal diffusé est du nickel.

6. Procédé selon l'une quelconque des revendications 1 à 5, caractérisé par le fait que le substrat semi-conducteur (20) est en silicium, la diffusion du métal ou du composé métallique sur la face avant due au recuit produisant un siliciure.

7. Procédé selon les revendications 5 et 6, caractérisé par le fait que le recuit s'effectue entre 200 et 350°C pour un siliciure Ni₂Si.

8. Procédé selon les revendications 5 et 6, caractérisé par le fait que le recuit s'effectue entre 350 et 750°C pour un siliciure NiSi.

9. Procédé selon l'une quelconque des revendications 1 à 4, caractérisé par le fait que le métal diffusé est choisi dans le groupe constitué par le chrome, le titane et le tungstène.

## Patentansprüche

1. Elektrolytisches Niederschlagsverfahren eines magnetischen Materials auf ein Halbleitersubstrat, das die folgenden Schritte umfasst:
- man verwendet ein schwach resistives Halbleitersubstrat (20),
- man scheidet auf einer Vorderseite (21) des Substrats ein Metall oder eine metallische Verbindung ab an den Stellen (31), wo der elektrolytische Niederschlag ausgeführt werden soll,
- man tempert das Ganze, damit ein Teil des Metalls oder der metallischen Verbindung in das Substrat diffundiert,
- man entfernt die auf dem Substrat verbliebenen Reste des Metalls oder der metallischen Verbindung,
- man bringt die Vorderseite (21) in Kontakt mit einer dem niederzuschlagenden Material entsprechenden elektrolytischen Lösung,
- man bringt das Substrat auf ein angemessenes Potential, um einen elektrolytischen Niederschlag (36) des genannten Materials auf den diffundierten Stellen (34) zu bewirken.

2. Verfahren nach Anspruch 1, dadurch gekennzeichnet, daß man auf der Vorderseite des Substrats eine isolierende Schicht (30) abscheidet, man diese isolierende Schicht ätzt, um Senken (31) zu bilden, man auf der geätzten, isolierenden Schicht und auf dem Boden der Senken eine Schicht aus Metall oder aus einer metallischen Verbindung (32) abscheidet, man das Ganze tempert, um das Metall oder die metallische Verbindung in das Substrat am Boden der Senken diffundieren zu lassen, man die restliche Metallschicht auf der isolierenden Schicht und am Boden der Senken entfernt und man in den Senken auf den diffundierten Stellen (34) den elektrolytischen Niederschlag (36) bildet.

3. Verfahren nach Anspruch 2, dadurch gekennzeichnet, daß man vorhergehend das Substrat ätzt, Gräben (33) entsprechend, und man die Senken am Boden dieser Gräben bildet.

4. Verfahren nach einem der Ansprüche 1 bis 3, dadurch gekennzeichnet, daß das magnetische Material ein Material auf Nickelbasis ist.

5. Verfahren nach einem der Ansprüche 1 bis 4, dadurch gekennzeichnet, daß das diffundierte Material Nickel ist.

6. Verfahren nach einem der Ansprüche 1 bis 5, dadurch gekennzeichnet, daß das Halbleitersubstrat (20) aus Silicium ist, wobei die Diffusion des Metalls oder der metallischen Verbindung auf der Vorderseite ein Silicid erzeugt, hervorgerufen durch das Tempern.

7. Verfahren nach den Ansprüchen 5 und 6, dadurch gekennzeichnet, daß das Tempern durchgeführt wird zwischen 200 und 350°C für ein Silicid Ni₂Si.

8. Verfahren nach den Ansprüchen 5 und 6, dadurch gekennzeichnet, daß das Tempern durchgeführt wird zwischen 350 und 750°C für ein Silicid NiSi.

9. Verfahren nach einem der Ansprüche 1 bis 4, dadurch gekennzeichnet, daß das diffundierte Metall gewählt wird aus der Gruppe, die gebildet wird durch das Chrom, das Titan und das Tungsten.

## Claims

1. Method of electroplating magnetic material onto a semiconductor substrate, which comprises the following operations:
- a weakly resistive semiconductor substrate (20) is used,
- a metal or a metallic compound is deposited onto a front face (21) of the substrate at locations (31) where the electroplating is to be performed,
- the assembly is annealed in order to make a part of the metal or of the metallic compound diffuse into the substrate,
- the metal or the metallic compound remaining on the substrate is removed,
- the front face (21) is brought into contact with an electrolytic solution corresponding to the material to be deposited,
- the substrate is raised to a potential suitable for causing electroplating (36) of the said material onto the diffused locations (34).

2. Method according to Claim 1, characterized in that an insulating layer (30) is deposited onto the front face of the substrate, this insulating layer is etched in order to forms wells (31), a layer (32) of metal or of metallic compound is deposited on the etched insulating layer and at the bottom of the wells, the assembly is annealed in order to make the metal or the metallic compound diffuse into the substrate at the bottom of the wells, the metallic layer remaining on the insulating layer and at the bottom of the wells is removed and the electroplating (36) in the wells is formed on the diffused locations (34).

3. Method according to Claim 2, characterized in that the substrate is etched beforehand into trenches (33) and the wells are formed at the bottom of these trenches.

4. Method according to any one of Claims 1 to 3, characterized in that the magnetic material (26) is a nickel-based material.

5. Method according to any one of Claims 1 to 4, characterized in that the diffused metal is nickel.

6. Method according to any one of Claims 1 to 5, characterized in that the semiconductor substrate (20) is made of silicon, the diffusion of the metal or of the metallic compound on the front face, due to the annealing, producing a silicide.

7. Method according to Claims 5 and 6, characterized in that the annealing is carried out between 200 and 350°C for a Ni₂Si silicide.

8. Method according to Claims 5 and 6, characterized in that the annealing is carried out between 350 and 750°C for a NiSi silicide.

9. Method according to any one of Claims 1 to 4, characterized in that the diffused metal is chosen from the group constituted by chromium, titanium and tungsten.
